# EUROPÄISCHE PATENTSCHRIFT

(11) **EP 3 492 795 B1**
(45) Veröffentlichungstag und Bekanntmachung des Hinweises auf die Patenterteilung: **03.09.2025**
(21) Anmeldenummer: 18193577.6
(22) Anmeldetag: 11.09.2018
(51) Int. Cl.: F16L 53/38, C09D 11/52, H05K 3/40, H05K 1/16, H05K 1/18

(54) **SCHLAUCH MIT GEDRUCKTER ELEKTRONIK**
HOSE WITH PRINTED ELECTRONICS
TUYAU AVEC ELECTRONIQUE IMPRIMÉE

(30) Priorität: 30.11.2017 DE 102017221542
(43) Veröffentlichungstag der Anmeldung: 05.06.2019
(73) Patentinhaber: ContiTech Deutschland GmbH, 30175 Hannover (DE)
(72) Erfinder: Huber, Tobias, 93161 Sinzing (DE); Gallner, Thomas, 93049 Regensburg (DE); Senne, Armin, 77955 Ettenheim (DE)
(74) Vertreter: Preusser, Andrea

(56) Entgegenhaltungen:
- EP-A1- 2 161 421
- EP-A1- 2 711 169
- EP-A1- 2 921 242
- DE-A1- 102014 018 372
- DE-U1- 20 103 434
- DE-U1- 202005 004 602
- DE-U1- 202015 007 999
- US-A1- 2016 312 924
- US-A1- 2017 094 800
- OPTOMEC.COM: "Optomec to Feature Systems for 3D Printed Electronics at UK Advanced Packaging Conference- Optomec", 15 March 2017 (2017-03-15), XP055520207, Retrieved from the Internet <URL:https://www.optomec.com/optomec-feature-systems-3d-printed-electronics-uk-advanced-packaging-conference/> [retrieved on 20181030]
- MARTINA OHLE: "Schaltungen und Sensoren aus dem Drucker - Presseinformation - 06.Mai 2014", 6 May 2014 (2014-05-06), XP055520218, Retrieved from the Internet <URL:https://www.ifam.fraunhofer.de/content/dam/ifam/de/documents/IFAM-Bremen/presse/2014/Pressemitteilung_IFAM_2014_Schaltungen%20und%20Sensoren%20aus%20dem%20Drucker.pdf> [retrieved on 20181030]

## Beschreibung

Die vorliegende Erfindung betrifft einen Schlauch, gemäß dem Oberbegriff des Patentanspruchs 1.

Heutzutage sind Schläuche aus z.B. Kautschuk, Kunststoff oder Metall bekannt, welche beispielsweise die Funktion der Medienführung von Fluiden, d.h. von Gasen und Flüssigkeiten, erfüllen.

Werden Anforderungen über diese Medienführung hinaus gestellt wie z.B. das Heizen und bzw. oder Kühlen eines Fluid, so ergeben sich i.d.R. komplexe Systeme und Aufbauten. Beispielsweise kommen in modernen Diesel-Fahrzeugen SCR-Lösungen (selective catalytic reduction) zum Einsatz, welche die Emissionen von Stickoxide reduzieren sollen. Hierzu wird ein Harnstoff wie z.B. Ammoniak den Abgasen beigemischt.

Dabei ist zu beachten, dass der Harnstoff eine bestimmte Temperatur aufweisen muss, um über ein Schlauchsystem zum Abgas hin geführt werden zu können. Wird nämlich eine Temperatur von ca. -10°C unterschritten, geht der Harnstoff vom flüssigen in den festen Aggregatszustand über und kann nicht mehr geführt bzw. gefördert werden.

Um die Funktion eines SCR-Systems auch bei Umgebungstemperaturen nutzen zu können, bei denen der Harnstoff eigentlich nicht mehr flüssig wäre, weisen heutige SCT-Systeme üblicherweise Widerstandsdrähte zum Beheizen des Schlauches auf. Die Widerstandsdrähte werden üblicherweise um den Schlauch gewickelt, um durch den Schlauch hindurch die Temperatur des Fluids erhöhen zu können.

Nachteilig ist hierbei, dass sich ein vergleichsweise komplexer Aufbau des Schlauches selbst ergeben kann, indem von innen nach außen der fluidführende Schlauchkörper, der Heizdraht in Form von Widerstandsdrähten sowie eine Ummantelung vorgesehen werden müssen. Auch müssen die elektrischen Anschlüsse der Heizdrähte angeordnet werden.

Die US 2016/312924 A1 beschreibt ein doppelwandiges Rohr mit integrierter Heizfähigkeit für ein Luft- oder Raumfahrzeug mit einem Rohrkörper, der starr aus Kunststoff in einem Stück mit einer Innenwand, mit einer Außenwand und mit einer Vielzahl von Wandstützen ausgebildet ist, wobei die Wandstützen die Innenwand mit der Außenwand verbinden, die Innenwand und die Außenwand einen Zwischenraum definieren. Das doppelwandige Rohr beinhaltet weiterhin eine elektrisch leitfähige Beschichtung, die die Innenwand innerhalb des Zwischenraums umgibt und konfiguriert ist, um sich unter Anlegen eines elektrischen Stroms so zu erwärmen, dass Wärme an die Innenwand abgegeben wird. Das doppelwandige Rohr wird samt elektrisch leitfähiger Beschichtung mittels 3D-Druck als ein Stück hergestellt.

Die DE 10 2014 018 372 A1 beschreibt eine konfektionierte beheizbare Medienleitung mit einer schlauch- oder rohrförmigen Medienleitung und mit zumindest einem endseitig an dieser angeordneten Leitungsverbinder, wobei die Medienleitung eine Leitungswandung und einen inneren, von der Leitungswandung umgebenen Hohlraum aufweist, wobei die Leitungswandung eine Außenseite und eine Innenseite aufweist, wobei zumindest eine Einrichtung zum Beheizen der Medienleitung vorgesehen ist, wobei die Einrichtung zum Beheizen der Medienleitung zumindest ein elektrisch leitfähiger Lack ist, der auf der Außen- und bzw. oder Innenseite der Leitungswandung zumindest einschichtig vorgesehen ist und wobei die Medienleitung zum Kontaktieren des leitfähigen Lacks mit zumindest zwei elektrischen Leitern versehen ist, die in elektrischem Kontakt mit dem elektrisch leitfähigen Lack stehen, wobei die elektrischen Leiter als Draht und bzw. oder Folie und bzw. oder Litze und bzw. oder Leiterbahn und bzw. oder mit der Medienleitung koextrudierte Elektroden auf der Leitungswandung aufgebracht sind. Der elektrisch leitfähige Lack wird nach der Extrusion der Medienleitung aufgesprüht und bzw. oder durchläuft die Medienleitung nach der Extrusion ein Lackbad eines elektrisch leitfähigen Lacks und bzw. oder ein elektrisch leitfähiger Lack wird durch ein Tauchverfahren oder Auftragsverfahren auf die Leitungswandung aufgebracht.

Optomec.Com, "Optomec to Feature Systems for 3D Printed Electronics at UK Advanced Packaging Conference- Optomec", (20170315), URL: https://www.optomec.com/optomec-feature-systems-3d-printed-electronics-uk-advanced-packaging-conference/, (20181030), beschreibt ein Aerosol-Jet-Systeme für 3D-Elektronik.

Martina Ohle, "Schaltungen und Sensoren aus dem Drucker - Presseinformation - 06.Mai 2014", (20140506), URL: https://www.ifam.fraunhofer.de/content/dam/ifam/de/documents/IFAM-Bremen/presse/2014/Pressemitteilung_IFAM_2014_Schaltungen%20und%20Sensoren%2 0aus%20dem%20Drucker.pdf, (20181030) beschreibt Schaltungen und Sensoren aus dem Drucker.

Die EP 2 711 169 A1 beschreibt ein Rohr mit mindestens einem Innenrohr und mindestens einem Informationsträger. Ferner weist das Rohr ein das mindestens eine Innenrohr umgebendes äußeres Hüllrohr auf, in dem oder in dessen Wand der mindestens eine Informationsträger angeordnet ist. Das äußere Hüllrohr ist für elektromagnetische Strahlung im sichtbaren Wellenlängenbereich transparent und weist ein teilkristallines Polyolefin-Material auf.

Die EP 2 161 421 A1 beschreibt eine Vorrichtung zur Lagerung eines flüssigen NOx-Reduktionsmittels in einem Fahrzeug. Die Vorrichtung umfasst einen Behälter zur Aufnahme des flüssigen NOx-Reduktionsmittels, eine erste Heizvorrichtung, die sich in dem Behälter befindet und dazu geeignet ist, das NOx-Reduktionsmittel im Gebrauch zu erhitzen, und ein Rohr, das ein erstes Ende aufweist, das dazu geeignet ist, im Gebrauch in das flüssige NOx-Reduktionsmittel in dem Behälter eingetaucht zu werden. Das Rohr ist geeignet, flüssiges NOx-Reduktionsmittel aus dem Behälter zu extrahieren, und das Rohr umfasst eine zweite Heizvorrichtung, die sich entlang mindestens eines Teils der Länge des Rohrs erstreckt, das sich innerhalb des Behälters befindet. Die EP 2 921 242 A1 offenbart einen Pressfitting mit einer zylindrischen Außenfläche, die einen Dehnungssensor enthält, der durch Tintenstrahldruck mit leitfähigen und/oder resistiven Tinten auf die Mantelfläche gedruckt ist.

Aufgabe der vorliegenden Erfindung ist es, einen Schlauch, der eingangs beschriebenen Art mit verbesserten und bzw. oder mit erweiterten Funktionen bereit zu stellen. Vorzugsweise soll dies möglichst einfach und bzw. oder möglichst kostengünstig erreicht werden. Zumindest soll eine Alternative zu bekannten derartigen Schläuche bereitgestellt werden.

Die Aufgabe wird erfindungsgemäß durch einen Schlauch, mit den Merkmalen gemäß Patentanspruch 1 gelöst. Vorteilhafte Weiterbildungen sind in den Unteransprüchen beschrieben.

Somit betrifft die vorliegende Erfindung einen Schlauch, mit wenigstens einer ersten Schicht, welche einen Innenraum umschließt. Mit anderen Worten weist der Schlauch einen Innenraum auf, in dem ein Stoff wie z.B. ein Fluid zur Lagerung und bzw. oder zum Transport aufgenommen werden kann. Der Innenraum kann auch als Hohlraum bezeichnet werden.

Ist der Schlauch zylindrisch ausgebildet, so dass insbesondere ein Fluid geführt werden kann, so ist der Innenraum zur Führung eines Fluids in Umfangsrichtung geschlossen ausgebildet. Der Innenraum erstreckt sich in diesem Fall im Wesentlichen in einer Längsrichtung, in welcher sich auch der zylindrische Schlauch erstreckt. Radial um diesen Innenraum herum ist die erste Schicht angeordnet und zylinderförmig ausgebildet. Somit erstreckt sich die erste Schicht in der Längsrichtung und ist in Umfangsrichtung geschlossen ausgebildet.

Erfindungsgemäß ist der zylindrische Schlauch durch wenigstens eine gedruckte Elektronik gekennzeichnet, welche von außen auf der ersten Schicht durch Drucken angeordnet ist.

Der Erfindung liegt dabei die Erkenntnis zugrunde, dass durch das Aufdrucken wenigstens einer Elektronik von außen auf die erste Schicht verschiedene Funktionen einfacher, kostengünstiger und bzw. oder wirkungsvoller als bisher bekannt bei dem Schlauch geschaffen werden können. Vorzugsweise können diese Funktionen besser als bisher bekannt in den Schlauch integriert werden. Auch können bisher nicht umsetzbare Funktionen bei dem Schlauch geschaffen bzw. in den Hohlkörper integriert werden.

Diese Funktionen werden im Folgenden näher erläutert werden.

Es können lediglich eine gedruckte Elektronik oder auch mehrere gedruckte Elektroniken verwendet werden. Auch können mehrere gedruckte Elektroniken verwendet werden, um die gleichen Funktionen mehrfach bzw. an mehreren Stellen des Hohlkörpers und bzw. oder unterschiedliche Funktionen einzeln oder miteinander kombiniert zu realisieren. Diese Funktionen können dabei z.B. sensorischer Art und bzw. oder aktuatorischer Art sein, wie im Folgenden näher erklärt werden wird. Auch kann z.B. ein elektrischer Strom bzw. eine elektrische Spannung in den Hohlkörper z.B. in ein Fluid eingeleitet werden können. Ebenso kann ein magnetisches Feld erzeugt werden, welches in den Hohlkörper z.B. auf ein Fluid wirken kann.

Zu beachten ist hierbei, dass die erste Schicht in direktem Kontakt mit dem innenseitigen Innenraum stehen kann, so dass auch die erste Schicht als innerste Schicht in direktem Kontakt mit z.B. einem Fluid stehen kann, welches sich in dem Innenraum befindet. Hierdurch können die Funktionen, welche durch die gedruckte Elektronik ausgeübt werden können, möglichst nah an dem Innenraum bzw. an dem Fluid angeordnet werden. Dies kann die Wirkung der gedruckten Schaltung z.B. als Aktor oder als Heizelement auf das Fluid besonders wirkungsvoll werden lassen. Umgekehrt kann die gedruckte Elektronik als z.B. Sensor bessere Messergebnisse liefern, wenn die gedruckte Elektronik möglichst nah an dem Innenraum bzw. an dem Fluid angeordnet ist.

In diesen Fällen kann es besonders vorteilhaft sein, die erste Schicht möglichst dünnwandig auszuführen, so dass zum einen zwar noch ein Bedrucken der ersten Schicht möglich ist, gleichzeitig jedoch die Wechselwirkung zwischen z.B. dem Fluid im Innenraum und der gedruckten Elektronik durch die geringe radiale Dicke der ersten innersten Schicht möglichst ausgeprägt sein kann.

Die erste Schicht kann jedoch auch durch wenigstens eine weitere nicht näher benannte und betrachtete weitere Schicht, welche innerhalb der ersten Schicht angeordnet ist, zu dem Innenraum beabstandet sein. Hierdurch kann eine räumliche Trennung von erster Schicht und Innenraum erreicht werden, um z.B. die erste Schicht chemisch zu schützen.

Die Herstellung der gedruckten Elektronik kann über ein Druckverfahren oder über die Kombination verschiedener Druckverfahren erfolgen, wie im Folgenden näher erläutert werden wird. Nicht Teil der Erfindung, kann die gedruckte Elektronik teilweise oder vollständig durch Strukturierung beim Extrudieren insbesondere eines zylindrischen Hohlkörpers sowie durch die Verwendung von unterschiedlichen Materialien ausgebildet werden, oder vollständig durch das Einlegen von Strukturen wie z.B. Flies oder Gitter ausgebildet werden.

Zur Ausbildung der elektrisch leitfähigen Strukturen der gedruckten Elektronik kann vorzugsweise eine funktionelle Farbe verwendet werden. Hierdurch können elektrisch leifähige Strukturen geschaffen werden, welche z.B. lediglich eine Höhe von ca. 20 Mikrometern aufweisen, so dass ein mehrschichtiger Aufbau des Hohlkörpers möglichst wenig beeinflusst werden kann.

Vorzugsweise wird die gedruckte Elektronik lediglich abschnittsweise auf der ersten Schicht angeordnet, so dass ausreichend Abschnitte verbleiben, welche frei von gedruckter Elektronik sind. Hierdurch kann ausreichend Oberfläche der ersten Schicht freigehalten werden, um eine ausreichende direkte Haftung mit ggfs. einer weiteren Schicht zu erreichen.

Gemäß einem Aspekt der vorliegenden Erfindung weist der Schlauch wenigstens eine zweite Schicht auf, welche von außen auf der ersten Schicht und auf der gedruckten Elektronik angeordnet ist. Hierdurch kann der Schlauch mit wenigstens einer weiteren Schicht versehen werden, welche z.B. eine Verstärkungsschicht mit einem Festigkeitsträger sein kann. Alternativ oder zusätzlich kann die zweite Schicht die erste Schicht sowie die gedruckte Elektronik nach außen hin abdecken und hierdurch vor äußeren Einflüssen schützen.

Gemäß einem weiteren Aspekt der vorliegenden Erfindung ist die gedruckte Elektronik ausgebildet, die erste Schicht zu erwärmen. Dies kann z.B. dadurch erreicht werden, dass die gedruckte Elektronik zumindest abschnittsweise wenigstens einen ohmschen Widerstand aufweist, welcher bei Bestromung durch Stromwärmeverluste Wärme erzeugen und über die erste Schicht an den Innenraum wie z.B. an ein dort befindliches Fluid abgeben kann, um dieses zu erwärmen.

Gemäß einem weiteren Aspekt der vorliegenden Erfindung ist die gedruckte Elektronik als Sensor, vorzugsweise als Temperatursensor und bzw. oder als Drucksensor, ausgebildet. Hierdurch kann wenigstens eine Eigenschaft der ersten Schicht sensorisch erfasst werden, welche aus dem Innenraum auf die erste Schicht ausgeübt werden kann. Beispielsweise kann ein im Innenraum befindliches Fluid seine Temperatur auf die erste Schicht übertragen, so dass die Temperatur des Fluid mit einer geringen zeitlichen Verzögerung aufgrund der thermischen Leitfähigkeit der ersten Schicht von der gedruckten Elektronik erfasst werden kann. Dies gilt entsprechend zusätzlich oder alternativ für einen Druck, welcher von dem Innenraum bzw. dem dort befindlichen z.B. Fluid auf die erste Schicht ausgeübt werden kann.

Auch können Dehnungsmessstreifen als Bestandteil der gedruckten Elektronik ausgebildet werden. Ferner ist es möglich, den ohmschen Widerstand bzw. dessen Veränderung in einem Abschnitt der gedruckten Elektronik insbesondere bei einem flexibel ausgebildeten Schlauch zu erfassen. Ebenso sind über die gedruckte Elektronik die sensorischen Erfassungen der Dichte und bzw. oder der Leitfähigkeit z.B. eines Fluids innerhalb des Schlauchs denkbar.

Gemäß einem weiteren Aspekt der vorliegenden Erfindung ist die gedruckte Elektronik als Aktor ausgebildet. Dies bedeutet, dass die gedruckte Elektronik zumindest abschnittsweise ausgebildet ist, Kräfte auf wenigstens die erste Schicht auszuüben. Diese Kräfte können seitens der gedruckten Elektronik z.B. durch einen piezoelektrischen Effekt und bzw. oder durch elektromechanische Aktuatorik ausgeübt werden. Diese Kräfte können z.B. die erste Schicht zumindest abschnittsweise zusammenziehen, so dass z.B. der Querschnitt des Innenraums verengt werden kann. Dies kann z.B. bei einem zylindrischen Schlauch zu einer gezielten Verringerung der Durchflussmenge z.B. eines Fluids führen.

Gemäß einem weiteren Aspekt der vorliegenden Erfindung ist die gedruckte Elektronik als Antenne ausgebildet. Hierdurch können elektromagnetische Wellen von der gedruckten Elektronik empfangen und bzw. oder ausgesendet werden. Dies kann eine unidirektionale oder bidirektionale Kommunikation zwischen der gedruckten Elektronik und der Umgebung ermöglichen.

Gemäß einem weiteren Aspekt der vorliegenden Erfindung weist die gedruckte Elektronik wenigstens einen Anschlussbereich auf, welcher ausgebildet ist, einen elektrisch leitfähigen Kontakt nach außerhalb des Schlauchs herzustellen, wobei der Anschlussbereich eine größere Stärke als die gedruckte Elektronik aufweist. Mit anderen Worten dient der Anschlussbereich dazu, wenigstens einen elektrisch leitfähigen Kontakt des Schlauchs mit einem Gegenstand wie z.B. einer Spannungsquelle, einer Steuerungsvorrichtung oder dergleichen herzustellen, welcher nicht Bestandteil des Schlauchs ist.

Hierzu kann es vorteilhaft sein, den Anschlussbereich stärker als die übrigen Leiterbahnen der gedruckten Elektronik auszubilden, um die Leitfähigkeit in diesem Bereich zu erhöhen.

Es ist auch möglich, die erste Schicht z.B. mittels eines Laserverfahrens soweit zu vertiefen und diesen Bereich als Anschlussbereich z.B. in einem Rakelprozess mit einer leitfähigen Füllung zu befüllen, dass ein fester Anschlussbereich nach außen ausgebildet werden kann.

Gemäß einem weiteren Aspekt der vorliegenden Erfindung erstreckt sich der Schlauch im Wesentlichen in einer Längsrichtung und der Anschlussbereich ist in der Längsrichtung an einem Ende des zylindrischen Schlauchs angeordnet. Hierdurch kann der Schlauch endseitig kontaktiert werden, was vorteilhaft ist, da an den Enden üblicherweise der mechanische Anschluss eines Schlauches erfolgt und dies gleichzeitig mit dem elektrischen Anschluss verknüpft werden kann.

Gemäß einem weiteren Aspekt der vorliegenden Erfindung weist der Schlauch, vorzugsweise die erste Schicht und bzw. oder die zweite Schicht des Schlauchs, ein elastomeres Material auf, vorzugsweise besteht aus einem elastomeren Material. Hierdurch ein flexibler Schlauch geschaffen werden

Erfindungsgemäß ist die gedruckte Elektronik mittels eines Flexodruckverfahrens, mittels eines Tiefdruckverfahrens, mittels eines Siebdruckverfahrens und bzw. oder mittels eines Digitaldruckverfahrens auf der ersten Schicht angeordnet. Somit können verschiedene Druckverfahren angewendet werden, um die jeweiligen Eigenschaften zu nutzen, um einen erfindungsgemäßen Schlauch auszubilden. Dies bietet eine hohe Freiheit bei der Gestaltung der gedruckten Elektronik sowie bei der Anwendung der vorliegenden Erfindung.

Mit anderen Worten können Druckverfahren verwendet werden, welche im direkten Druckprozess die Druckfarbe als gewünschte Strukturen wie z.B. Antennenstruktur, Leiterbahnstruktur oder Heizstruktur auf die erste Schicht des Schlauchs aufbringen. Nicht Teil der Erfindung, können in einem vorbereitenden Schritt die gewünschten Strukturen wie z.B. Antennenstruktur, Leiterbahnstruktur oder Heizstruktur z.B. durch Gravieren, insbesondere durch Lasergravieren, in die erste Schicht eingebracht und anschließend mit der funktionellen Flüssigkeit, welche elektrisch leitfähige, magnetische und ähnliche Eigenschaften aufweist, gefüllt werden.

Ein Ausführungsbeispiel und weitere Vorteile der Erfindung werden nachstehend im Zusammenhang mit der folgenden Figur erläutert. Darin zeigt:

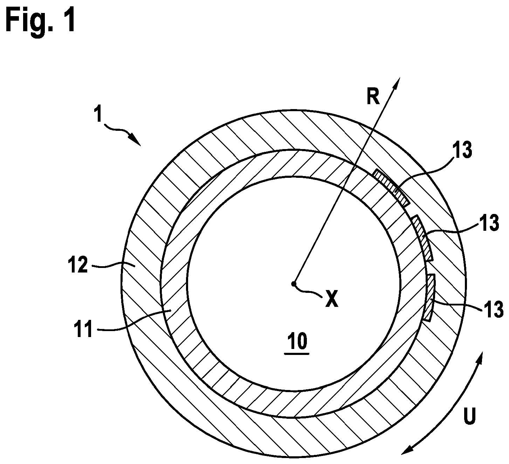

Fig. 1 eine schematische Schnittdarstellung eines erfindungsgemäßen Schlauchs.

Fig. 1 zeigt eine schematische Schnittdarstellung eines erfindungsgemäßen Schlauchs 1.

Der erfindungsgemäße Schlauch 1 erstreckt sich Wesentlichen in einer Längsrichtung (senkrecht zur Ebene der Darstellung der Figur 1).

Der Schlauch 1 weist eine erste Schicht 11 auf, welche auch als innerste Schicht 11 bezeichnet werden kann. Die erste Schicht 11 erstreckt sich entsprechend der Form des Schlauches 11 in dessen Längsrichtung, ist in Umfangsrichtung U geschlossen ausgebildet sowie radial zur Achse der Längsrichtung, d.h. zur Längsachse X, beabstandet. Die erste Schicht 11 schließt hierdurch einen Innenraum 10 ein, welcher an den beiden Enden des Schlauches 1 offen und zugänglich ist. In dem Innenraum 10 kann ein Fluid geführt werden.

Radial von außen ist auf einem Abschnitt der ersten Schicht 11 eine gedruckte Elektronik 13 vorgesehen. Die gedruckte Elektronik 13 kann alternativ oder miteinander kombiniert unterschiedliche Funktionen wie z.B. einen Sensor oder mehrere gleiche oder unterschiedliche Sensoren, ein Heizelement oder mehrere gleiche oder unterschiedliche Heizelemente, eine Antenne oder mehrere gleiche oder unterschiedliche Antennen und bzw. oder einen Aktor oder mehrere gleiche oder unterschiedliche Aktoren aufweisen.

Von radial außen ist eine zweite Schicht 12 auf der ersten Schicht 11 und auf der gedruckten Elektronik 13 angeordnet, um die gedruckte Elektronik 13 zu schützen. Die zweite Schicht kann gleichzeitig Festigkeitsträger aufweisen, um dem Schlauch 1 eine höhere Festigkeit zu geben.

### Bezugszeichenliste (Teil der Beschreibung)

- R: radiale Richtung
- U: Umfangsrichtung
- X: Längsachse

- 1: (flexibler, zylindrischer) Hohlkörper; Schlauch
- 10: Innenraum
- 11: erste, innerste Schicht
- 12: zweite Schicht
- 13: gedruckte Elektronik; gedruckte elektronische Schaltung

## Patentansprüche

1. Schlauch (1), mit
wenigstens einer ersten Schicht (11), welche einen Innenraum (10), vorzugsweise zur Führung eines Fluids, umschließt, und
mit wenigstens einer gedruckten Elektronik (13), welche von außen auf der ersten Schicht (11) durch Drucken angeordnet ist,
**dadurch gekennzeichnet, dass**
die gedruckte Elektronik (13) mittels eines Flexodruckverfahrens, mittels eines Tiefdruckverfahrens, mittels eines Siebdruckverfahrens und/oder mittels eines Digitaldruckverfahrens auf der ersten Schicht (11) angeordnet wurde.

2. Schlauch (1) nach Anspruch 1, **gekennzeichnet durch**
wenigstens eine zweite Schicht (12), welche von außen auf der ersten Schicht (11) und auf der gedruckten Elektronik (13) angeordnet ist.

3. Schlauch (1) nach Anspruch 1 oder 2, **dadurch gekennzeichnet, dass**
die gedruckte Elektronik (13) ausgebildet ist, die erste Schicht (11) zu erwärmen.

4. Schlauch (1) nach einem der vorherigen Ansprüche, **dadurch gekennzeichnet, dass**
die gedruckte Elektronik (13) als Sensor, vorzugsweise als Temperatursensor und/oder als Drucksensor, ausgebildet ist.

5. Schlauch (1) nach einem der vorherigen Ansprüche, **dadurch gekennzeichnet, dass**
die gedruckte Elektronik (13) als Aktor ausgebildet ist.

6. Schlauch (1) nach einem der vorherigen Ansprüche, **dadurch gekennzeichnet, dass** die gedruckte Elektronik (13) als Antenne ausgebildet ist.

7. Schlauch (1) nach einem der vorherigen Ansprüche, **dadurch gekennzeichnet, dass** die gedruckte Elektronik (13) wenigstens einen Anschlussbereich aufweist, welcher ausgebildet ist, einen elektrisch leitfähigen Kontakt nach außerhalb des Schlauchs (1) herzustellen,
wobei der Anschlussbereich eine größere Stärke als die gedruckte Elektronik (13) aufweist.

8. Schlauch (1) nach Anspruch 7, **dadurch gekennzeichnet, dass**
der Schlauch (1) sich im Wesentlichen in einer Längsrichtung erstreckt, und
der Anschlussbereich in der Längsrichtung an einem Ende des zylindrischen Körpers (1) angeordnet ist.

9. Schlauch (1) nach einem der vorherigen Ansprüche, **dadurch gekennzeichnet, dass** der Schlauch (1), vorzugsweise die erste Schicht (11) und/oder die zweite Schicht (12) des Schlauchs (1), ein elastomeres Material aufweist, vorzugsweise aus einem elastomeren Material besteht.

## Claims

1. Hose (1), with
at least one first layer (11), which encloses an interior (10), preferably for guiding a fluid, and
at least one set of printed electronics (13), which is arranged on the first layer (11) from the outside by printing,
**characterized in that**
the set of printed electronics (13) has been arranged on the first layer (11) by means of a flexographic printing process, by means of a gravure printing process, by means of a screen printing process and/or by means of a digital printing process.

2. Hose (1) according to Claim 1, **characterized by**
at least one second layer (12), which is arranged on the first layer (11) and on the set of printed electronics (13) from the outside.

3. Hose (1) according to Claim 1 or 2, **characterized in that**
the set of printed electronics (13) is designed to heat the first layer (11).

4. Hose (1) according to any of the preceding claims, **characterized in that**
the set of printed electronics (13) is designed as a sensor, preferably as a temperature sensor and/or as a pressure sensor.

5. Hose (1) according to any of the preceding claims, **characterized in that**
the set of printed electronics (13) is designed as an actuator.

6. Hose (1) according to any of the preceding claims, **characterized in that**
the set of printed electronics (13) is designed as an antenna.

7. Hose (1) according to any of the preceding claims, **characterized in that**
the set of printed electronics (13) has at least one connection region, which is designed to make electrically conductive contact outside the hose (1),
wherein the connection region is thicker than the set of printed electronics (13).

8. Hose (1) according to Claim 7, **characterized in that**
the hose (1) extends substantially in a longitudinal direction, and
the connection region is arranged in the longitudinal direction at one end of the cylindrical body (1).

9. Hose (1) according to any of the preceding claims, **characterized in that**
the hose (1), preferably the first layer (11) and/or the second layer (12) of the hose (1), comprises an elastomeric material, preferably consists of an elastomeric material.

## Revendications

1. Tuyau flexible (1) avec
au moins une première couche (11), qui renferme un espace intérieur (10), de préférence pour guider un fluide, et
avec au moins une électronique imprimée (13), qui est disposée par impression sur la première couche (11) depuis l'extérieur,
**caractérisé en ce que**
l'électronique imprimée (13) a été disposée sur la première couche (11) par un procédé de flexographie, un procédé d'impression en creux, un procédé de sérigraphie, et/ou un procédé d'impression numérique.

2. Tuyau flexible (1) selon la revendication 1, **caractérisé par**
au moins une deuxième couche (12), qui est disposée sur la première couche (11) et sur l'électronique imprimée (13) depuis l'extérieur.

3. Tuyau flexible (1) selon la revendication 1 ou 2, **caractérisé en ce que**
l'électronique imprimée (13) est réalisée pour chauffer la première couche (11).

4. Tuyau flexible (1) selon l'une des revendications précédentes, **caractérisé en ce que**
l'électronique imprimée (13) est réalisée en tant qu'un capteur, de préférence en tant qu'un capteur de température et/ou en tant qu'un capteur de pression.

5. Tuyau flexible (1) selon l'une des revendications précédentes, **caractérisé en ce que**
l'électronique imprimée (13) est réalisée en tant qu'un actionneur.

6. Tuyau flexible (1) selon l'une des revendications précédentes, **caractérisé en ce que**
l'électronique imprimée (13) est réalisée en tant qu'une antenne.

7. Tuyau flexible (1) selon l'une des revendications précédentes, **caractérisé en ce que**
l'électronique imprimée (13) comporte au moins une zone de raccordement, qui est réalisée pour établir un contact électriquement conducteur vers l'extérieur du tuyau flexible (1),
la zone de raccordement présentant une épaisseur plus importante que celle de l'électronique imprimée (13).

8. Tuyau flexible (1) selon la revendication 7, **caractérisé en ce que**
le tuyau flexible (1) s'étend sensiblement dans une direction longitudinale, et
la zone de raccordement est disposée, dans la direction longitudinale, sur une extrémité du corps cylindrique (1).

9. Tuyau flexible (1) selon l'une des revendications précédentes, **caractérisé en ce que**
le tuyau flexible (1), de préférence la première couche (11) et/ou la deuxième couche (12) du tuyau flexible (1), comporte un matériau élastomère, de préférence est constitué d'un matériau élastomère.
